# EUROPÄISCHE PATENTSCHRIFT

(11) **EP 2 917 747 B1**
(45) Veröffentlichungstag und Bekanntmachung des Hinweises auf die Patenterteilung: **08.01.2020**
(21) Anmeldenummer: 13830170.0
(22) Anmeldetag: 07.11.2013
(51) Int. Cl.: G01R 31/02, H05B 6/06, H05B 6/28

(54) **VERFAHREN UND VORRICHTUNG ZUR ERDSCHLUSSLOKALISIERUNG BEI EINEM INDUKTIONSOFEN SOWIE INDUKTIONSOFEN**
METHOD AND DEVICE FOR LOCATING AN EARTH FAULT IN AN INDUCTION FURNACE, AND AN INDUCTION FURNACE
PROCÉDÉ ET DISPOSITIF DE LOCALISATION D'UN DÉFAUT À LA TERRE DANS UN FOUR À INDUCTION, AINSI QUE FOUR À INDUCTION

(30) Priorität: 09.11.2012 DE 102012021904; 19.02.2013 DE 102013002795
(43) Veröffentlichungstag der Anmeldung: 16.09.2015
(73) Patentinhaber: ABP Induction Systems GmbH, 44147 Dortmund (DE)
(72) Erfinder: TEMME, Ingolf, 58708 Menden (DE); GREEN, Daniel, Clark, NJ 07066 (US)
(74) Vertreter: Hauck Patentanwaltspartnerschaft mbB
(86) Internationale Anmeldenummer: PCT/DE2013/000661
(87) Internationale Veröffentlichungsnummer: WO 2014/071913

(56) Entgegenhaltungen:
- EP-A1- 0 291 156
- EP-A2- 0 185 887
- EP-A2- 1 818 638
- WO-A1-95/31028
- US-A- 4 293 730

## Beschreibung

Die vorliegende Erfindung betrifft ein Verfahren zum Erkennen eines Erdschlusses bei einem Induktionsofen, der einen Induktionsofenmantel mit einer Feuerfestauskleidung und einer diese umgebenden Induktionsspule und mindestens eine Erdungselektrode im unteren Teil der Feuerfestauskleidung sowie eine Erdschlusserkennungseinrichtung umfasst.

Ein derartiges Verfahren ist bekannt. Hierbei wird mit Hilfe der Erdschlusserkennungseinrichtung festgestellt, ob im System ein Erdschluss vorhanden ist. Eine derartige Erdschlusserkennungseinrichtung bzw. Überwachungseinrichtung ist mit der Induktionsspule verbunden und umfasst beispielsweise eine Signalquelle und einen Komparator, der den Erdungswiderstand der Induktionsspule und ihres Versorgungsstromkreises misst. Die Einrichtung verfügt über einen Fensterkomparator mit einstellbarem oberen und unteren Grenzwert, der den gemessenen Widerstand mit oberen und unteren Schwellwerten abgleicht. Wenn der gemessene Widerstand unter den unteren Grenzwert fällt, gibt die Erdschlusserkennungseinrichtung einen Alarm aus, der die Stromversorgung abschaltet und dem Bediener signalisiert, dass ein Erdschluss vorliegt. Wenn der gemessene Widerstand über den oberen Grenzwert steigt, gibt die Erdschlussüberwachungseinrichtung einen Alarm aus, der die Stromversorgung abschaltet und dem Bediener signalisiert, dass der Messkreis für den Erdungswiderstand defekt ist.

Ein derartiger Erdschluss kann durch einen Schluss zwischen Spule und Erde, zwischen der Energieversorgung und Erde oder zwischen anderen spannungsführenden Teilen außerhalb der Spule und Erde entstehen. Dazu kann ein Erdschluss zur Induktionsofenspule oder Stromversorgung oder anderen spannungsführenden Komponenten gehören, die sich außerhalb der Spule befinden. Ein Spulenerdschluss kann ferner durch Durchdringen der Metallschmelze durch die Feuerfestauskleidung verursacht werden. In diesem Fall wird eine Erdverbindung durch die mindestens eine Erdungselektrode des Bades bereitgestellt.

Ein Problem bei bekannten Arten von derartigen Erdschlusserkennungs- bzw. Überwachungseinrichtungen von Induktionsöfen besteht darin, dass zwar das Auftreten eines Erdschlusses erkannt und angezeigt wird, jedoch nicht angezeigt wird, wo der Erdschluss auftritt. Das Wartungspersonal muss daher im Falle eines Erdschlusses entsprechende Zonen im Bereich des Ofens zwecks Fehlersuche überprüfen. Dies ist zeit- und kostenaufwändig.

Aus der EP 0 185 887 A2 sind ein Verfahren und eine Vorrichtung zum Lokalisieren eines Erdschlusses an einem spulenförmigen elektrischen Leiter bekannt. Die Stelle eines Erdschlusses an der Spule wird ermittelt, indem eine elektrische Eigenschaft an einer ersten Stelle in Bezug auf Erde bestimmt wird, die Eigenschaft zwischen der ersten Stelle und einer zweiten Stelle gemessen wird und das entsprechende Verhältnis berechnet wird. Zum Detektieren des Auftretens eines Erdschlusses kann ein Monitor Verwendung finden, der die Position entlang der Länge der Spule, an der der Erdschluss auftritt, ermittelt.

Die EP 1 818 638 A2 beschreibt ein Verfahren zur Überwachung eines Induktionsofens und einen Induktionsofen. Um einen Fehler in der Spulen-Joch-Isolation einfacher und schneller orten zu können, wird an jedem einzelnen Joch unabhängig von den anderen Jochen eine Änderung eines elektrischen Isolationszustandes in Relation zu der Induktionsspule und/oder dem Erdpotential erfasst. Danach wird die Lokalisierung einer sich anbahnenden oder vorliegenden Schadstelle in der Spulen-Joch-Isolation vorgenommen.

Die US 4 293 730 beschreibt ein Verfahren und eine Vorrichtung zum Detektieren eines Erdschlusses an einem elektrischen Ofen, wobei eine im Ofen angeordnete Elektrode geerdet und der von der Elektrode zur Erde fließende Strom gemessen wird.

Der vorliegenden Erfindung liegt die Aufgabe zugrunde, ein Verfahren der eingangs wiedergegebenen Art zur Verfügung zu stellen, das zu einer Sicherheitserhöhung beim Betreiben des Ofens führt.

Diese Aufgabe wird erfindungsgemäß durch ein Verfahren gemäß Patentanspruch 1 gelöst.

Bei dem erfindungsgemäßen Verfahren wird daher nicht nur erkannt bzw. festgestellt, dass ein Erdschluss aufgetreten ist, sondern der entsprechende Erdschluss wird auch lokalisiert. Mit anderen Worten, es wird erfindungsgemäß festgestellt, wo der Erdschluss aufgetreten ist. Dabei wird insbesondere lokalisiert, ob der Erdschluss durch ein Versagen der Feuerfestauskleidung oder durch andere Ursachen verursacht wird. Speziell wird ermittelt, ob der Erdschluss durch Durchdringen der Badmetallschmelze des Ofens durch die Feuerfestauskleidung zur Induktionsspule verursacht wird.

Hierbei wird der Erdschluss erfindungsgemäß lokalisiert, indem die mindestens eine Erdungselektrode von Erdung getrennt und dann geprüft wird, ob der Erdschluss weiter besteht oder nicht.

Es muss daher nicht, wie bei der bekannten Erdschlusserkennungseinrichtung, die Ursache für den Erdschluss manuell gesucht werden. Vielmehr wird, wenn ein Erdschluss mit Hilfe der Erdschlusserkennungseinrichtung festgestellt wird, der nach der Ofenabschaltung weiterbesteht, das Abschaltsignal der Erdschlussmessung erfindungsgemäß nochmals überprüft. Wenn hierbei festgestellt wird, dass der Erdschluss weiterbesteht, wird die mindestens eine Erdungselektrode von Erdung getrennt. Ergibt die Prüfung, dass der Erdschluss dann nicht mehr angezeigt wird, besteht ein Defekt in der Feuerfestauskleidung, da der Spulenstrom (Prüfstrom) über den direkten Kontakt mit dem Metallbad in Folge der fehlerhaften Feuerfestauskleidung nicht mehr über die Erdungselektrode zu Erde abfließen kann. Besteht jedoch der Erdschluss nach der Trennung der Erdungselektrode von Erdung weiter, wird festgestellt, dass der Erdschluss andere Ursachen hat bzw. sich der Fehler außerhalb der Feuerfestauskleidung befindet.

Durch Abschalten bzw. Zuschalten der Erdverbindung der mindestens einen Erdungselektrode kann daher der Erdschluss insofern lokalisiert werden, als dass festgestellt werden kann, ob er auf ein Versagen der Feuerfestauskleidung, beispielsweise durch Durchdringen der Feuerfestauskleidung durch die Metallschmelze und Kontakt derselben mit der Spule, oder auf anderen Ursachen, die nichts mit der Feuerfestauskleidung zu tun haben, basiert.

Bei Feststellung, dass der Erdschluss durch andere Ursachen verursacht wird, wird ermittelt, ob der Erdschluss durch eine fehlerhafte Magnetjochisolierung verursacht wird. Hierbei wird, wenn der Erdschluss weiterbesteht, die Stromversorgung kurzzeitig angeschaltet, um zu überprüfen, ob ein externer Erdschluss vorliegt, der nur eintritt, wenn Spannung vorhanden ist. Wenn der Erdschluss wiederkehrt, wird der Fehler "externer Erdschluss" angezeigt und es werden sämtlich Jochtrennschaltvorrichtungen, die den Magnetjochen zugeordnet sind, zusammen geöffnet. Besteht der Fehler dann nicht weiter, wird der Fehler "Jochisolierungsfehler" angezeigt.

Es wird dann ermittelt, welches Magnetjoch des Induktionsofens einen Erdschluss verursacht. Dabei werden sämtliche Magnetjochtrennschaltvorrichtungen geschlossen und werden die Jochtrennschaltvorrichtungen dann automatisch nacheinander geöffnet. Jedes Mal, wenn eine Jochtrennschaltvorrichtung geöffnet wird, wird geprüft, ob der Erdschluss nicht mehr besteht. Wenn dies eintritt, kann eine Fehlermeldung "Isolierungsfehler Jochnummer" angezeigt werden. Das Verfahren kann fortgesetzt werden, bis alle Joche einzeln geprüft wurden.

Das erfindungsgemäße Verfahren zum Lokalisieren eines Erdschlusses findet vorzugsweise in Kombination mit einem Verfahren Verwendung, bei dem die Intaktheit der mindestens einen Erdungselektrode überprüft wird. Mit der Überprüfung der Intaktheit der Erdungselektrode ist hierbei auch die Überprüfung der elektrischen Verbindung zwischen dem Schmelzbad und der entsprechenden Erdung gemeint. Dieses Verfahren liefert die zusätzliche Sicherheit, dass die Erdschlusserkennung über die mindestens eine Erdungselektrode auch funktioniert.

Vorzugsweise wird hierbei bei der Prüfung der Intaktheit an eine weitere durch den Ofenboden führende und mit der Schmelze in Verbindung stehende isolierte Elektrode ein niedriger Gleich- oder Wechselstrom gelegt, der von dieser Elektrode durch das Schmelzbad zu der mindestens einen Erdungselektrode gegen Erde fließt, und wird dieser Strom nach dem Schmelzen der Charge gemessen, insbesondere kontinuierlich, und mit einem Bezugswert verglichen. Fällt die Größe des Stromes unter den Bezugswert, wird ein einen Defekt der Erdungselektrode anzeigendes Alarmsignal erzeugt. Vorzugsweise wird dabei die Stromversorgung zum Ofen abgeschaltet.

Auf diese Weise wird mit dem erfindungsgemäßen Verfahren sichergestellt, dass die Erdschlusserkennungseinrichtung des Induktionsofens in der Lage ist, einen Erdschlussalarm im Falle eines Durchdringens der Metallschmelze durch die Feuerfestauskleidung des Induktionsofens bereitzustellen. Dies bildet die Grundlage des erfindungsgemäßen Verfahrens zum Lokalisieren des aufgetretenen Erdschlusses.

Die Erfindung ist ferner auf eine Vorrichtung zur Durchführung des vorstehend beschriebenen Verfahrens gerichtet. Die Vorrichtung ist dadurch gekennzeichnet, dass sie eine Einrichtung zum Lokalisieren eines festgestellten Erdschlusses umfasst. Insbesondere ermittelt die Einrichtung zum Lokalisieren, ob der Erdschluss durch ein Versagen der Feuerfestauskleidung oder durch andere Ursachen verursacht wird. Speziell ermittelt die Einrichtung dabei, ob der Erdschluss durch Durchdringen der Badmetallschmelze des Ofens durch die Feuerfestauskleidung zur Induktionsspule verursacht wird.

Die Einrichtung zum Lokalisieren weist dabei speziell eine Schaltvorrichtung, insbesondere ein Relais, zum Trennen der mindestens einen Erdungselektrode von Erdung auf. Ferner weist die Einrichtung zum Lokalisieren eine Vielzahl von Schaltvorrichtungen, insbesondere Relais, zum Trennen der Magnetjoche von Erdung auf.

Die erfindungsgemäße Vorrichtung besitzt vorteilhafterweise eine Einrichtung zur Überprüfung der Intaktheit der mindestens einen Erdungselektrode. Diese Vorrichtung kann hierbei vorzugsweise so ausgebildet sein, dass sie eine zusätzliche isolierte Elektrode, die durch den Ofenboden geführt ist, eine Niederspannungsquelle zum Anlegen eines niedrigen Gleich- oder Wechselstromes an die zusätzliche Elektrode, eine Einrichtung zum Messen dieses Stromes, eine Einrichtung zum Vergleichen der Größe dieses Stromes mit einem Bezugswert und eine Einrichtung zum Erzeugen eines Alarmsignals, wenn der Strom unter den Bezugswert fällt, aufweist.

Des Weiteren betrifft die Erfindung einen Induktionsofen mit einem Induktionsofenmantel mit einer Feuerfestauskleidung, die zur Aufnahme einer Badschmlze ausgebildet ist, einer Induktionsspule, die die Feuerfestauskleidung umgibt und lagert und so ausgebildet ist, dass sie beim Anlegen eines Stromes die Badschmelze auf induktive Weise erhitzt, und einer Vorrichtung zum Feststellen eines Erdschlusses mit mindestens einer Baderdungselektrode im unteren Teil der Feuerfestauskleidung, einer Erdschlusserkennungseinrichtung und einer Einrichtung zum Lokalisieren eines festgestellten Erdschlusses, die in der vorstehend beschriebenen Weise ausgebildet ist.

Die Erfindung wird nachfolgend anhand von Ausführungsbeispielen in Verbindung mit der Zeichnung im Einzelnen erläutert. Es zeigen:
- Figur 1: eine schematische Darstellung eines Induktionsofens, der mit einer Erdschlusserkennungseinrichtung sowie mit einer Vorrichtung zum Lokalisieren eines Erdschlusses versehen ist;
- Figur 2: eine schematische Darstellung eines Induktionsofens entsprechend Figur 1, der zusätzlich mit einer Vorrichtung zum automatischen Erkennen der Intaktheit einer Erdungselektrode versehen ist; und
- Figur 3: ein Ablaufdiagramm zur Verwirklichung des Verfahrens zum Lokalisieren eines Erdschlussfehlers.

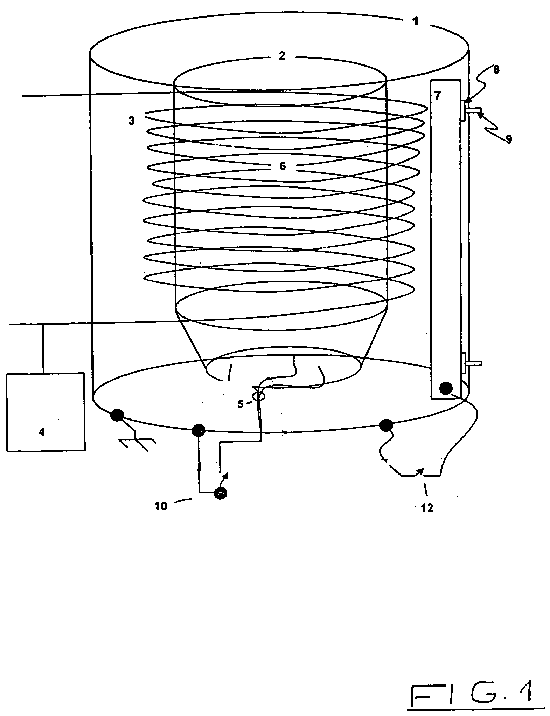

Der in Figur 1 schematisch dargestellte Induktionsofen besitzt einen Induktionsofenmantel 1, der eine Feuerfestauskleidung 2 umfasst, die von einer Induktionsspule 3 umgeben und gestützt wird. Die Feuerfestauskleidung 2 enthält ein Bad aus einer Metallschmelze, die im Induktionsofen geschmolzen wird. Die Induktionsspule 3 wird zudem von mehreren Magnetjochen 7 gestützt, die wiederum durch Isolierplatten 8 gestützt werden, welche durch Jochbolzen 9 unter Spannung gehalten werden. Die Funktion der Magnetjoche besteht darin, das Magnetfeld, das durch die Induktionsspule 3 erzeugt wird, zu führen und zu verhindern, dass es den Ofenmantel überhitzt, und die Induktionsspule 3 zudem mechanisch abzustützen.

Die Isolierplatten 8 sind zwischen den Jochen und ihren Spannbolzen angeordnet, damit ein Erdschluss, der außerhalb der Ofenspule liegt, einem spezifischen Joch zugeordnet werden kann.

Der Induktionsofen besitzt eine Erdschlusserkennungs- bzw. Überwachungseinrichtung 4, die mit der Induktionsspule 3 verbunden ist. Die Einrichtung umfasst eine Signalquelle und einen Komparator, der den Erdungswiderstand der Induktionsspule und ihres Versorgungsstromkreises misst (in Figur 1 nicht gezeigt). Die Erdschlussüberwachung verfügt über einen Fensterkomparator mit einstellbarem oberen und unteren Grenzwert, der den gemessenen Widerstand mit oberen und unteren Schwellwerten abgleicht. Wenn der gemessene Widerstand unter den unteren Grenzwert fällt, gibt die Erdschlussüberwachung einen Alarm aus, der die Stromversorgung abschaltet und dem Bediener signalisiert, dass ein Erdschluss vorliegt. Wenn der gemessene Widerstand über den oberen Grenzwert steigt, gibt die Erdschlussmessung einen Alarm aus, der die Stromversorgung abschaltet und dem Bediener signalisiert, dass der Messkreis für den Erdungswiderstand defekt ist.

Ein solcher Erdschluss kann durch einen Schluss zwischen Spule und Erdung, zwischen der Energieversorgung und Erde oder zwischen anderen spannungsführenden Teilen außerhalb der Spule und Erde entstehen. Dazu kann ein Erdschluss zur Induktionsofenspule oder Stromversorgung oder anderen spannungsführenden Komponenten gehören, die sich außerhalb der Spule befinden. Ein Spulenerdschluss kann ferner durch Durchdringen der Metallschmelze durch die Feuerfestauskleidung verursacht werden. In diesem Fall wird eine Erdverbindung durch die Erdungselektroden 5 des Bades bereitgestellt.

Um einen aufgetretenen Erdschluss lokalisieren zu können, ist in der Erdverbindung der Erdungselektrode 5 eine Schaltvorrichtung 10 in Form eines Relais vorgesehen. Mit dieser Schaltvorrichtung kann die Erdungselektrode 5 von Erde getrennt werden.

Die Erdschlusserkennungseinrichtung 4 stellt das Auftreten eines Erdschlusses fest und schaltet den Ofen automatisch ab, wenn ein Erdschluss auftritt. Wenn der Erdschluss nach der Ofenabschaltung weiterbesteht, wird das Abschaltsignal der Erdschlusserkennungseinrichtung 4 nochmals überprüft. Hierzu wird das Relais der Schaltvorrichtung 10 geöffnet, wenn der Erdschluss weiterbesteht. Wenn der Erdschluss dann nicht mehr angezeigt wird (infolge der Trennung von Erde), besteht ein Defekt in der Feuerfestauskleidung, da nunmehr der Stromfluss von der Spule durch die Feuerfestauskleidung über das Metallbad und die Erdungselektrode 5 zu Erde unterbrochen ist. Besteht der Erdschluss hingegen weiter, so befindet sich der Fehler außerhalb der Feuerfestauskleidung bzw. wird durch andere Ursachen erzeugt.

Weiterhin kann automatisch festgestellt werden, ob ein Erdschluss, der außerhalb des Ofens liegt, durch ein oder mehrere Magnetjoche verursacht wird, und ferner erkannt werden, welches spezifische Joch den Fehler verursacht. Hierzu sind spezielle Jochtrennvorrichtungen 12 in Form von Relais vorgesehen.

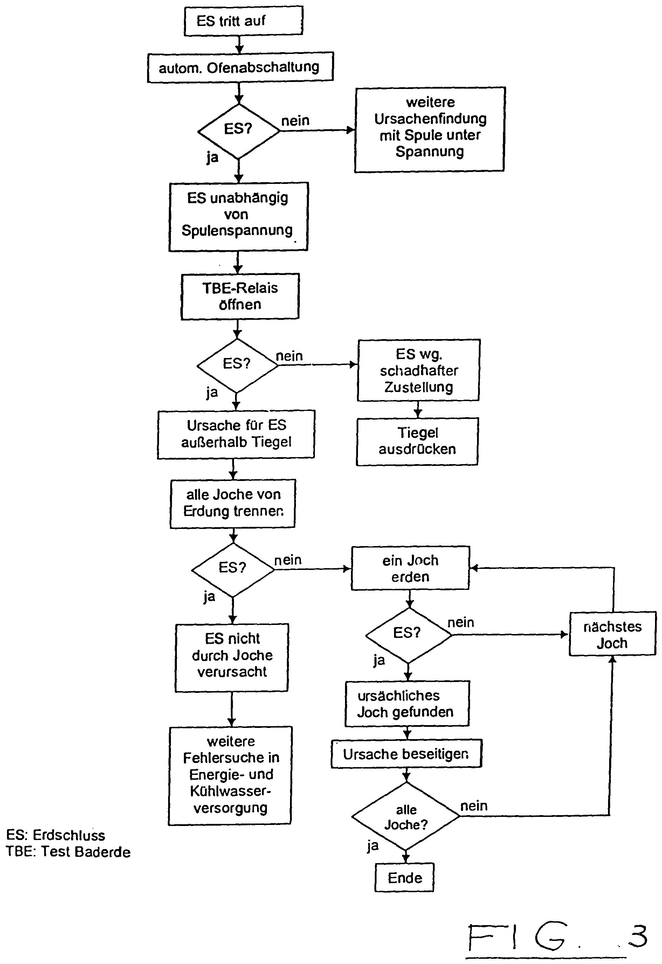

Der Verfahrensablauf zum Lokalisieren eines Erdschlussfehlers ist im Ablaufdiagramm der Figur 3 dargestellt. Läuft der Induktionsofen normal, liegen keine Erdschlüsse und Alarme vor. Die Schaltvorrichtung (Relais)10 und die Jochtrennschaltvorrichtungen (Relais) 12 sind geschlossen. Liegt jedoch ein Erdschluss vor, gibt das System ein Erdschlussalarmsignal aus, das die Stromversorgung zum Ofen abschaltet. Das Regelsystem öffnet sodann automatisch die Schaltvorrichtung 10. Wenn der Erdschluss nicht weiterbesteht, zeigt das System den Fehler "Defekt in der Feuerfestauskleidung" an. Wenn der Erdschluss weiterbesteht, schaltet das System die Stromversorgung kurzzeitig an, um zu prüfen, ob ein externer Erdschluss vorliegt, der nur eintritt, wenn Spannung vorhanden ist. Wenn der Erdschluss wiederkehrt, zeigt das System den Fehler "externer Erdschluss" an und öffnet anschließend sämtliche Jochtrennvorrichtungen 12 zusammen. Besteht der Fehler nicht weiter, zeigt das System den Fehler "Jochisolierungsfehler" an. Das System schließt anschließend sämtliche Schaltvorrichtungen 12 und öffnet die Schaltvorrichtungen 12 automatisch nacheinander. In der Regel sind mehrere Joche (vier oder mehr) vorhanden, wobei die Menge der Jochtrennschaltvorrichtungen 12 der Anzahl der Joche entspricht. Jedes Mal, wenn eine Jochtrennschaltvorrichtung geöffnet wird, prüft das System, ob der Erdschluss nicht mehr besteht. Wenn dies eintritt, zeigt das System eine Fehlermeldung "Isolierungsfehler Jochnummer", wobei mit Nummer die Kennnummer des Jochs bezeichnet ist. Diese Testsequenz wird fortgesetzt, bis alle Joche einzeln geprüft wurden.

Ein Problem bei bekannten Arten der Erdschlussüberwachung von Induktionsöfen besteht darin, dass es keine automatisierte Möglichkeit gibt, zu ermitteln, ob die Erdungselektroden des Bades intakt sind und/oder einen guten elektrischen Kontakt zum Schmelzbad herstellen. Dabei ist die Intaktheit dieser Verbindung eine notwendige Voraussetzung dafür, dass die Erdschlusserkennungseinrichtung 4 feststellen kann, dass die Metallschmelze durch die Feuerfestauskleidung 2 gedrungen und mit der Induktionsspule 3 in Kontakt gekommen ist. Die Fähigkeit zur Feststellung einer solchen Durchdringung ist für den sicheren Betrieb eines Induktionsofens von wesentlicher Bedeutung.

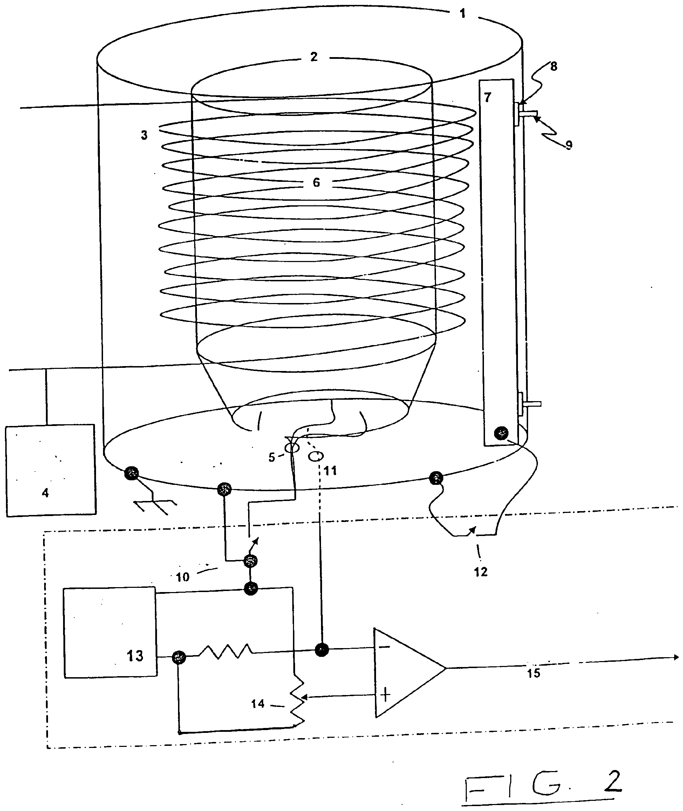

Figur 2 zeigt einen Induktionsofen, der neben einer Einrichtung zum Lokalisieren eines Erdschlusses eine Einrichtung zur Überprüfung der Intaktheit der mindestens einen Erdungselektrode 5 aufweist. Diese Einrichtung prüft automatisch, ob die Erdungselektroden intakt sind und/oder ob die elektrisch leitfähige Verbindung zwischen dem Metallschmelzbad 6 und den Erdungselektroden 5 des Bades aufrechterhalten wird. Dies wird mit Hilfe einer zusätzlichen isolierten Elektrode 11 erreicht, die durch den Ofenboden geführt ist. Ein niedriger Gleich- oder Wechselstrom von einer Niederspannungsquelle 13 wird durch diese Elektrode 11 durch das Schmelzbad in die übrigen Elektroden 5 gegen Erde geleitet. Die Größe dieses Stromes wird kontinuierlich gemessen und mit einem Bezugswert 14 verglichen, um sicherzustellen, dass der Strom über einem voreingestellten Mindestwert bleibt. Fällt die Größe des Stromes unter den Bezugswert, wird ein Alarmsignal 15 erzeugt, um die Stromversorgung zum Ofen abzuschalten und um eine Warnung an den Ofenbediener auszugeben, dass die Erdung des Ofenschmelzbades defekt ist. Hierdurch wird sichergestellt, dass die Erdschlussmessung (Erdschlusserkennungseinrichtung 4) des Induktionsofens in der Lage ist, einen Erdschlussalarm im Falle eines Durchdringens der Metallschmelze durch die Feuerfestauskleidung des Induktionsofens bereitzustellen.

## Patentansprüche

1. Verfahren zum Erkennen eines Erdschlusses bei einem Induktionsofen, der einen Induktionsofenmantel mit einer Feuerfestauskleidung und einer diese umgebenden Induktionsspule und mindestens eine Erdungselektrode im unteren Teil der Feuerfestauskleidung sowie eine Erdschlusserkennungseinrichtung umfasst,
wobei bei Feststellen eines Erdschlusses mithilfe der Erdschlusserkennungseinrichtung dieser lokalisiert wird, indem die mindestens eine Erdungselektrode von Erdung getrennt und dann geprüft wird, ob der Erdschluss weiterbesteht oder nicht,
und indem bei Feststellung, dass der Erdschluss nicht weiterbesteht, ein Defekt in der Feuerfestauskleidung festgestellt wird, und bei Feststellung, dass der Erdschluss weiterbesteht, ermittelt wird, ob der Erdschluss durch eine fehlerhafte Magnetjochisolierung verursacht wird, indem sukzessive sämtliche Magnetjoche von Erdung getrennt werden und geprüft wird, ob nach Trennung eines Magnetjoches der Erdschluss weiterbesteht oder nicht.

2. Verfahren nach Anspruch 1, **dadurch gekennzeichnet, dass** es ferner den Schritt der Überprüfung der Intaktheit der mindestens einen Erdungselektrode umfasst.

3. Verfahren nach Anspruch 2, **dadurch gekennzeichnet, dass** an eine weitere, durch den Ofenboden führende und mit der Schmelze in Verbindung stehende isolierte Elektrode ein niedriger Gleich- oder Wechselstrom gelegt wird, der von dieser Elektrode durch das Schmelzbad zu der mindestens einen Erdungselektrode gegen Erde fließt, dieser Strom nach dem Schmelzen der Charge gemessen und mit einem Bezugswert verglichen und bei Fallen der Größe des Stromes unter den Bezugswert ein einen Defekt der Erdungselektrode anzeigendes Alarmsignal erzeugt wird.

4. Vorrichtung zur Durchführung des Verfahrens nach einem der vorangehenden Ansprüche bei einem Induktionsofen, der einen Induktionsofenmantel (1) mit einer Feuerfestauskleidung (2) und einer diese umgebenden Induktionsspule (3) und mindestens eine Erdungselektrode (5) im unteren Teil der Feuerfestauskleidung (2) sowie eine Erdschlusserkennungseinrichtung (4) und eine Einrichtung zum Lokalisieren eines festgestellten Erdschlusses umfasst, die eine Schaltvorrichtung (10), insbesondere ein Relais, zum Trennen der mindestens einen Erdungselektrode (5) von Erdung, eine Prüfeinrichtung, ob der Erdschluss weiterbesteht oder nicht, sowie eine Vielzahl von Schaltvorrichtungen (12), insbesondere Relais, zum Trennen der Magnetjoche (7) von Erdung aufweist.

5. Vorrichtung nach Anspruch 4, **dadurch gekennzeichnet, dass** sie eine Einrichtung zur Überprüfung der Intaktheit der mindestens einen Erdungselektrode (5) aufweist.

6. Vorrichtung nach Anspruch 5, **dadurch gekennzeichnet, dass** sie eine zusätzliche isolierte Elektrode (11), die durch den Ofenboden geführt ist, eine Niederspannungsquelle (13) zum Anlegen eines niedrigen Gleich- oder Wechselstromes an die zusätzlich Elektrode (11), eine Einrichtung zum Messen dieses Stromes, eine Einrichtung zum Vergleichen der Größe dieses Stromes mit einem Bezugswert (14) und eine Einrichtung (15) zum Erzeugen eines Alarmsignals, wenn der Strom unter den Bezugswert (14) fällt, aufweist.

7. Induktionsofen mit
einem Induktionsofenmantel (1) mit einer Feuerfestauskleidung (2), die zur Aufnahme einer Badschmelze ausgebildet ist,
einer Induktionsspule (3), die die Feuerfestauskleidung (2) umgibt und lagert und so ausgebildet ist, dass sie beim Anlegen eines Stromes die Badschmelze auf induktive Weise erhitzt, und
einer Vorrichtung zum Feststellen eines Erdschlusses mit
mindestens einer Erdungselektrode (5) im unteren Teil der Feuerfestauskleidung (2),
einer Erdschlusserkennungseinrichtung (4) und
einer Einrichtung zum Lokalisieren eines festgestellten Erdschlusses, die eine Schaltvorrichtung (10), insbesondere ein Relais, zum Trennen der mindestens einen Erdungselektrode (5) von Erdung, eine Prüfeinrichtung, ob der Erdschluss weiterbesteht oder nicht, sowie eine Vielzahl von Schaltvorrichtungen (12), insbesondere Relais, zum Trennen der Magnetjoche (7) von Erdung aufweist.

## Claims

1. A method of detecting a ground fault in an induction furnace that has an induction furnace jacket with a refractory lining and an induction coil surrounding the refractory lining and at least one bath ground electrode in the lower part of the refractory lining as well as a ground fault detector,
wherein upon detection of a ground fault by means of the ground fault detector the ground fault is localized by separating the at least one bath ground electrode from ground and then checking whether the ground fault exists further or not,
and upon detection that the ground fault does not exist further determining a defect in the refractory lining and upon detection that the ground fault exists further determining whether the ground fault is caused by a defective magnetic yoke insulation by successively separating all the magnetic yokes from ground and checking whether the ground fault exists further or not after separation of one magnetic yoke.

2. The method according to claim 1, **characterized by** comprising the further step of checking the intactness of the at least one bath ground electrode.

3. The method according to claim 2, **characterized by** applying a low DC or AC current to a further insulated electrode extending through the furnace bottom and in connection with the melt, the current flowing from this electrode through the melt bath to the at least one bath ground electrode to ground, measuring this current after melting of the charge, and comparing this current with a reference value and generating an alarm signal indicating a defect of the bath ground electrode when the magnitude of the current drops below the reference value.

4. An apparatus for carrying out the method according to one of the preceding claims in an induction furnace which has an induction furnace jacket (1) with a refractory lining (2) and an induction coil (3) surrounding the refractory lining (2), and at least one bath ground electrode (5) in the lower part of the refractory lining (2) as well as a ground fault detector (4) and means for localizing a determined ground fault which has a switching device (10), especially a relay, for separating the at least one bath ground electrode (5) from ground, means for examining whether the ground fault exists further or not, as well as as plurality of switching devices (12), especially relays, for separating the magnetic yokes (7) from ground.

5. The apparatus according to claim 4, **characterized in that** it has means for examining the intactness of the at least one bath ground electrode (5).

6. The apparatus according to claim 5, **characterized in that** it includes an additional insulated electrode (11) which extends through the furnace bottom, a low-voltage source (13) for applying a low DC or AC current to the additional electrode (11), means for measuring this current, means for comparing the magnitude of this current with a reference value (14), and means (15) for generating an alarm signal when the current drops below the reference value (14).

7. An induction furnace comprising
an induction furnace jacket (1) with a refractory lining (2) designed for receiving a bath melt,
an induction coil (3) surrounding and supporting the refractory lining (2) and designed in such a manner that it heats the bath melt in an inductive manner when a current is applied, and
an apparatus for determining a ground fault including
at least one bath ground electrode (5) in the lower part of the refractory lining (2),
a ground fault detector (4), and
means for localizing a determined ground fault comprising a switching device (10), especially a relay, for separating the at least one bath ground electrode (5) from ground, an examining device for determining whether the ground fault exists further or not, as well as a plurality of switching devices (12), especially relays, for separating the magnetic yokes (7) from ground.

## Revendications

1. Procédé de détection d'un défaut de terre dans un four à induction, qui comprend une enveloppe de four à induction avec un revêtement réfractaire et une bobine d'induction entourant celui-ci et au moins une électrode de terre dans la partie inférieure du revêtement réfractaire ainsi qu'un appareil de détection d'un défaut de terre,
dans lequel lors de la constatation d'un défaut de terre à l'aide de l'appareil de détection d'un défaut de terre, celui-ci est localisé par le fait que l'au moins une électrode de terre est coupée de la terre et ensuite il est vérifié si le défaut de terre persiste ou non,
et par le fait que lors de la constatation que le défaut de terre ne persiste pas, un défaut dans le revêtement réfractaire est constaté, et lors de la constatation que le défaut de terre persiste, il est déterminé si le défaut de terre est provoqué par un défaut d'isolation de la culasse magnétique, par le fait que progressivement toutes les culasses magnétiques sont coupées de la terre et il est vérifié si après la coupure d'une culasse magnétique, le défaut de terre persiste ou non.

2. Procédé selon la revendication 1, **caractérisé en ce qu'**il comprend en outre l'étape de contrôle de l'intégrité de l'au moins une électrode de terre.

3. Procédé selon la revendication 2, **caractérisé en ce qu'**est appliqué, sur une autre électrode isolée guidant à travers le fond de four et communiquant avec la matière fondue, un faible courant continu ou alternatif, qui circule de cette électrode à travers le bain de fusion vers l'au moins une électrode de terre contre la terre, ce courant est mesuré après la fusion de la charge et comparé avec une valeur de référence et dans les cas où la grandeur du courant est sous la valeur de référence, un signal d'alarme indiquant un défaut de l'électrode de terre est généré.

4. Dispositif de réalisation du procédé selon l'une quelconque des revendications précédentes dans un four à induction, qui comprend une enveloppe de four à induction (1) avec un revêtement réfractaire (2) et une bobine d'induction (3) entourant celui-ci et au moins une électrode de terre (5) dans la partie inférieure du revêtement réfractaire (2) ainsi qu'un appareil de détection d'un défaut de terre (4) et un appareil de localisation d'un défaut de terre constaté, qui présente un dispositif de commutation (10), en particulier un relais, pour couper au moins une électrode de terre (5) de la terre, un appareil pour vérifier si le défaut de terre persiste ou non, ainsi qu'une pluralité de dispositifs de commutation (12), en particulier relais, pour couper les culasses magnétiques (7) de la terre.

5. Dispositif selon la revendication 4, **caractérisé en ce qu'**il présente un appareil de contrôle de l'intégrité de l'au moins une électrode de terre (5).

6. Dispositif selon la revendication 5, **caractérisé en ce qu'**il présente une électrode isolée supplémentaire (11), qui est guidée à travers le fond de four, une source de basse tension (13) pour l'application d'un faible courant continu ou alternatif sur l'électrode supplémentaire (11), un appareil de mesure de ce courant, un appareil de comparaison de la grandeur de ce courant avec une valeur de référence (14) et un appareil (15) de génération d'un signal d'alarme, lorsque le courant tombe sous la valeur de référence (14).

7. Four à induction avec
une enveloppe de four à induction (1) avec un revêtement réfractaire (2), qui est réalisé pour la réception d'une matière fondue de bain,
une bobine d'induction (3), qui entoure et loge le revêtement réfractaire (2) et est réalisée de sorte qu'elle chauffe la matière fondue de bain par induction lors de l'application d'un courant, et
un dispositif de constatation d'un défaut de terre avec
au moins une électrode de terre (5) dans la partie inférieure du revêtement réfractaire (2),
un appareil de détection d'un défaut de terre (4) et
un appareil de localisation d'un défaut de terre constaté, qui présente un dispositif de commutation (10), en particulier un relais, pour couper l'au moins une électrode de terre (5) de la terre, un appareil pour vérifier si le défaut de terre persiste ou non, ainsi qu'une pluralité de dispositifs de commutation (12), en particulier relais, pour couper les culasses magnétiques (7) de la terre.
